# EUROPÄISCHE PATENTSCHRIFT

(11) **EP 1 395 633 B1**
(45) Veröffentlichungstag und Bekanntmachung des Hinweises auf die Patenterteilung: **05.11.2008**
(21) Anmeldenummer: 02724133.0
(22) Anmeldetag: 15.04.2002
(51) Int. Cl.: C08L 1/00

(54) **VERFAHREN ZUR ERZEUGUNG DÜNNER HOMOGENER SCHICHTEN MIT HILFE DER SIEBDRUCKTECHNIK**
METHOD FOR PRODUCING THIN HOMOGENEOUS LAYERS WITH THE HELP OF SCREEN PRINTING TECHNOLOGY
PROCEDE DE PRODUCTION DE COUCHES MINCES HOMOGENES PAR SERIGRAPHIE

(30) Priorität: 27.04.2001 DE 10120686
(43) Veröffentlichungstag der Anmeldung: 10.03.2004
(73) Patentinhaber: OSRAM Opto Semiconductors GmbH, 93055 Regensburg (DE)
(72) Erfinder: BERNDS, Adolf, 91083 Baiersdorf (DE); CLEMENS, Wolfgang, 90617 Puschendorf (DE); KNOBLOCH, Alexander, Friedrich, 91233 Neunkirchen (DE)
(74) Vertreter: Epping - Hermann - Fischer
(86) Internationale Anmeldenummer: PCT/DE2002/001400
(87) Internationale Veröffentlichungsnummer: WO 2002/088243

(56) Entgegenhaltungen:
- DE-A- 19 757 542
- DE-B- 1 260 424
- PATENT ABSTRACTS OF JAPAN vol. 2000, no. 20, 10. Juli 2001 (2001-07-10) & JP 2001 080034 A (TOSHIBA CORP), 27. März 2001 (2001-03-27)

## Beschreibung

Die vorliegende Erfindung betrifft ein Verfahren zur Erzeugung dünner homogener Schichten mit Hilfe der Siebdrucktechnik. Hier werden auch eine spezielle Vorrichtung zur Durchführung des Verfahrens sowie deren Verwendung bei der Herstellung von insbesondere Polymerelektronikbauteilen beschrieben. Das Verfahren ermöglicht die Massenproduktion dieser Teile.

Bei der Produktion von elektrischen bzw. elektronischen Bauteilen auf der Basis von organischem Material ist ein wesentlicher Aspekt die Erzeugung von Schichten hoher Homogenität und geringer Dicke. Es ist wesentlich, eine homogene Schichtdicke in einer Größenordnung von etwa 10 bis 2000 nm sicherzustellen, da die elektrische Funktionalität in einem erheblichen Maße davon abhängt.

Bisher wurden organische Schichten über das sogenannte Spin-Coating, ein viel verwendetes Reinraumverfahren, erzeugt. Dabei wird das zu beschichtende Substrat auf einen Drehteller gelegt und durch ein Vakuum angesaugt. Danach wird eine Lösung des organischen Materials auf das Substrat aufgebracht. Durch die anschließende Rotation des Drehtellers verteilt sich die Lösung ziemlich homogen auf dem Substrat. Die Schichtdicke lässt sich über die Drehgeschwindigkeit des Tellers und den Feststoffanteil der Lösung regulieren. Dieses Verfahren erzeugt Schichten von relativ hoher Güte, wobei eine deutliche Überhöhung zum Rand hin auftritt. Durch dieses Verfahren lässt sich kein hoher Durchsatz erzielen, da es sich dabei um einen diskontinuierlichen Prozess handelt. Auch ist die Größe des bearbeitbaren Substrates begrenzt.

Als alternatives Verfahren wurde eine Variante des Tintenstrahldruckes vorgeschlagen. Bei diesem Verfahren wird die Lösung des organischen Materiales in den Farbbehälter eines Tintenstrahldruckers gefüllt und dann wie herkömmliche Tinte verdruckt. Auch mit diesem Verfahren lassen sich nur eingeschränkte Produktionsgeschwindigkeiten erzielen und darüber hinaus erzeugen die einzelnen aus der Farbdüse austretenden Mikrotropfen eine Pixelung in der erzeugten Schicht und damit eine Inhomogenität.

Ein weiteres Beschichtungsverfahren ist das sogenannte Air-Brush-Verfahren. Dabei wird die aufzubringende Lösung des organischen Materiales in einen Luftstrom beigemengt. Die Beschichtung erfolgt über den Flüssigkeitsnebel. Bei diesem Verfahren wird wegen der einzelnen kleinen Flüssigkeitströpfchen ebenfalls keine homogene glatte Schicht erzeugt.

Eine weitere Technik, homogene Schichten auf ein Substrat aufzubringen, wäre das Siebdruckverfahren. Diese Technik wird auch verwendet, um einzelne Substrate Stück für Stück zu bedrucken. Beim Standard-Siebdruck muss jedoch das Substrat zum Bedrucken angehalten werden, was ein Massenfertigungsverfahren in wirtschaftlich vernünftiger Zeit und zu vernünftigen Kosten ausschließt.

Um den Siebdruck als Massenfertigungsverfahren zu etablieren, wurde bereits vorgeschlagen, die Druckform als einen starren Zylinder auszuführen. Man spricht hier vom Rotationssiebdruck. Beim Rotationssiebdruck kann das Substrat, zum Beispiel eine von einer Rolle kommende Folie, zwar kontinuierlich durchlaufen, was einen höheren Durchsatz ermöglicht. Bei diesem Verfahren wird jedoch ein starres Sieb aus einem stabilen Gewebe verwendet. Dies hat eine hohe Beanspruchung des zu bedruckenden Untergrundes zur Folge, so dass sich dieses System allgemein für Hochpräzisionsanwendungen, insbesondere für die Polymerelektronik, als ungeeignet erwiesen hat.

Aus der JP 2001 080034A ist eine Vorrichtung bekannt, wo ein endloses Band, das auf zwei Walzen geführt wird, an einem Druckmediengeber, dem in Laufrichtung eine Rakel nachgeordnet ist, vorbeigeführt wird. Im Wesentlichen wird das Band durch die Walzen geführt und in Position gehalten. Als Gegendrucksystem sind unterhalb des Bandes noch zwei Walzen mit einem Gegendruckband, das als Trägerband funktioniert, vorgesehen sind.

Der Standard-Siebdruck hat somit den Nachteil, dass ein Massenfertigungsverfahren aus wirtschaftlichen Gründen nicht möglich ist. Der schnellere Rotationssiebdruck ist für Hochpräzisionsanwendungen nicht geeignet.

Aufgabe der vorliegenden Erfindung war es daher, ein Siebdruck-Verfahren anzugeben, womit dünne homogene Schichten hoher Präzision wirtschaftlich in einem Massenfertigungsverfahren erzeugbar sind.

Gegenstand der vorliegenden Erfindung ist ein Verfahren zur Erzeugung dünner homogener Schichten mit Hilfe der Siebdrucktechnik, bei dem ein niederviskoses Druckmedium über ein auf wenigstens zwei Walzen geführtes, flexibles Siebband kontinuierlich oder diskontinuierlich auf ein zu bedruckendes Substrat übertragen wird.

Damit lassen sich hochqualitative Beschichtungen in Massenproduktionsverfahren herstellen. Nach dem erfindungsgemäßen Verfahren lassen sich alle Arten von Substraten, insbesondere flexible Substrate, wie beispielsweise Folien von einer Rolle, bedrucken. Das Verfahren ist deshalb besonders gut für die Herstellung von Polymerelektronikbauteilen geeignet.

Wesentliche Faktoren sind dabei das flexible Siebband, das vorzugsweise eine hohe Feinmaschigkeit aufweist, sowie die Verwendung sehr niederviskoser Druckmedien, was eine gleichförmige und gezielte Verteilung des Druckmediums auf einem Substrat ermöglicht.

Unter Substrat wird für den Anwendungsbereich Polymerelektronik, insbesondere eine Folie aus Polyethylen, Polyterephthalat oder besonders bevorzugt Polyimid verstanden. Das Substrat kann auch bereits beschichtet sein. Dies ist insbesondere der Fall, wenn ein ganzes Bauteil aus Polymerelektronik hergestellt wird.

Gemäß der vorliegenden Erfindung weist das Druckmedium vorzugsweise eine Viskosität von 1 bis 100 mPas auf. Dadurch wird ein gleichmäßiger, dünnflüssiger Strom durch das Sieb auf das Substrat und damit letztendlich eine größtmögliche Homogenität bei geringer Schichtdicke der Beschichtung ermöglicht.

Im Rahmen der vorliegenden Erfindung kann dabei das Druckmedium aus herkömmlichen Siebdruckfarben, Fotolacken oder organischen Verbindungen, insbesondere Polymerverbindungen, gelöst in zur Einstellung der Viskosität geeigneten Lösungsmitteln sein. Die Wahl des Lösungsmittels ist dabei weitgehend frei und meist nur abhängig von der Art des Druckmediums.

Diese Möglichkeit erfordert insbesondere keine Entwicklung neuer Substrate und/oder Druckmedien, sondern es können Materialien verwendet werden, welche im Stand der Technik üblicherweise leicht zugänglich sind.

Vorzugsweise werden die Lösungsmittel aus aliphatischen oder aromatischen Kohlenwasserstoffen mit einem Siedepunkt von ≥ 80°C ausgewählt werden. Diese Vorgehensweise ermöglicht die Vermeidung weiterer Reinigungsstufen des Siebbandes, da ein Austrocknen des Druckmediums vor, während oder nach der Übertragung auf das Substrat weitgehend ausgeschlossen bleibt.

Andererseits können auch Lösungsmittel mit einem Siedepunkt von ≤ 80°C eingesetzt werden, wobei dann aber der Übertrag des Druckmediums unter einer Atmosphäre des entsprechenden Lösungsmittels durchgeführt wird, um eben ein Austrocknen des Druckmediums und damit ein Verstopfen des Siebbandes zu vermeiden. Für besondere Anwendungszwecke liegt auch diese Ausführungsform im Rahmen des erfindungsgemäßen Verfahrens. Die Wahl eines speziellen Lösungsmittels wird immer von dem zu lösenden Medium abhängig sein, so dass auch diese letzte Ausführungsform ohne Abstriche an die Vorteile des erfindungsgemäßen Verfahrens durchgeführt werden kann.

Das Lösungsmittel kann rein oder als Gemisch zwei oder mehrerer Verbindungen/Lösungsmittel vorliegen.

In einer weiteren bevorzugten Ausführungsform lässt sich das Druckmedium auf das zu bedruckende Substrat strukturiert übertragen oder die Strukturierung wird in einem nachfolgenden Arbeitsschritt vorgenommen. Bei einem bereits strukturierten Übertragen ist das flexible Siebband vorab mit der gewünschten Strukturierung auszurüsten. Das bedeutet für den Fall, dass ein Substrat, respektive Folienband, das mit einer strukturierten Beschichtung ausgerüstet werden soll, entweder mittels eines entsprechend strukturierten, flexiblen Siebbandes bedruckt wird oder das Substrat vorab in entsprechender Weise präpariert wird, derart, dass nur an vorgesehenen Bereichen das Druckmedium auf dem Substrat haften bleibt oder das bereits aufgetragene Druckmedium durch eine nachfolgende Behandlung, wie beispielsweise einem Vernetzungsschritt, an vorgegebenen Positionen weiter verarbeitet wird.

Insbesondere für den Fall, dass mit dem erfindungsgemäßen Verfahren Polymerelektronikbauteile erzeugt werden sollen, werden die organischen Polymerverbindungen, welche auf das Substrat übertragen werden sollen, aus isolierenden, halbleitenden und/oder leitenden Polymeren ausgewählt werden.

Die bevorzugten leitenden Polymerverbindungen sind dabei Polyanilin (PANI) oder dotiertes Polyethylen (PEDOT). Bevorzugte halbleitende Polymerverbindungen sind konjugierte Polymere, vorzugsweise Polythiophene, Polythienylvinylene oder Perfluorderivate. Isolierende Polymerverbindungen sind Polyhydroxystyrole oder Hydroxylgruppen enthaltende Melamin-Formaldehyd-Harze.

Insbesondere zur strukturierten Beauftragung eines Substrates ist es von Vorteil, dass die Auftragsmenge und die Auftragsdauer des Druckmediums in Abhängigkeit von der gewünschten zu erzeugenden Schichtdicke regelbar ist. Auch das ist Gegenstand dieser Erfindung.

Das erfindungsgemäße Verfahren wird vorzugsweise zur Erzeugung bzw. zum Aufbau von Polymerelektronik verwendet. Insbesondere wird dabei an den Aufbau von aktiven Bauteilen einer organischen elektronischen Schaltung gedacht, wie integrierte Schaltungen, Gleichrichterdioden, oder auch an den Aufbau von passiven Bauteilen einer organischen elektronischen Schaltung, wie Widerstände, Kondensatoren, Spulen.

Eine Vorrichtung geeignet zur Übertragung niederviskoser Druckmedien auf ein Substrat zeichnet sich durch ein auf wenigstens zwei Walzen geführtes, endloses flexibles Siebband, einen Druckmediumgeber, dem in Laufrichtung des Siebbandes eine Rakel unmittelbar nachgeordnet ist, und einen unterhalb des Druckmediengebers und der Rakel angeordneten Gegendruckzylinder zur insbesondere gleichzeitigen Führung des Substrates aus.

In einer bevorzugten Ausführungsform der vorliegenden Vorrichtung zur Durchführung des erfindungsgemaßen Verfahrens ist die Auftragsmenge und die Auftragsdauer des über den Druckmediumgeber zuzuführenden Druckmediums in Abhängigkeit von der gewünschten zu erzeugenden Schichtdicke auf dem Substrat regelbar. Dazu eignen sich alle im Stand der Technik bekannten Vorrichtungen.

Der Vorrichtung kann auch eine Einrichtung zur thermischen Behandlung des beschichteten Substrates nachgeschaltet sein. Das betrifft eine besondere Ausführungsform der vorliegenden Erfindung, wenn nämlich eine Strukturierung der vorgenommenen Beschichtung erfolgen soll. Diese Strukturierung kann durch alle im Stand der Technik bekannten Verfahren vorgenommen werden. Die Einrichtung zur thermischen Behandlung kann durch Heizlampen oder beheizte Rollen ausgestaltet sein.

Die Vorrichtung wird als integraler Bestandteil in einem Prozess zur Erzeugung von Polymerelektronikbauteilen verwendet. Sie bildet dann eine Station in einem Gesamtherstellungsverfahren.

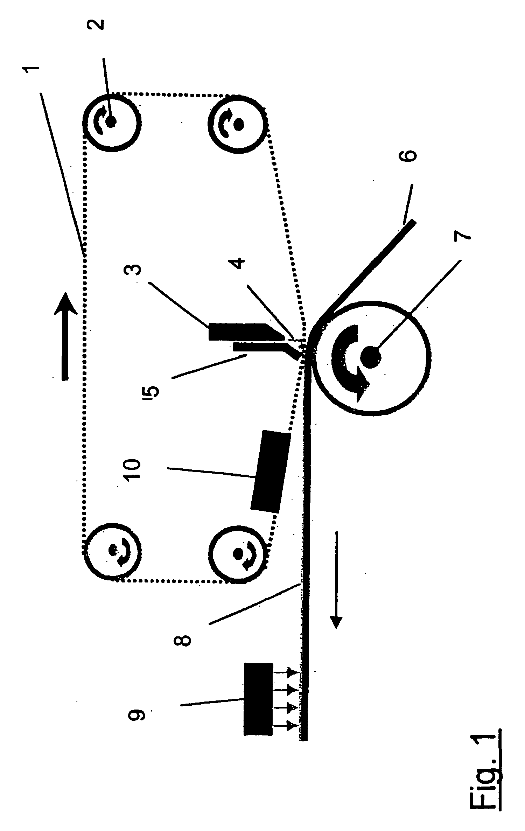

Das erfindungsgemäße Verfahren wird im Folgenden anhand der einzigen Fig. 1, welche die erfindungsgemäße Vorrichtung zeigt, erläutert.

Diese Vorrichtung verfügt dementsprechend über ein endloses, feinmaschiges Siebband 1, das in der gezeigten Ausführungsform über vier Walzen 2 geführt ist. Das Siebband 1 läuft im Uhrzeigersinn. Ein Druckmediumgeber 3 ist etwa zentral mittig vorgesehen, durch den das Druckmedium 4, insbesondere die gewünschte Polymerlösung abgegeben wird. Dem Druckmediumgeber 3 ist unmittelbar eine Rakel 5 nachgeordnet, welche das Druckmedium 4 gleichmäßig durch das Siebband 1 drückt. Unterhalb der Anordnung aus Druckmediumgeber 3 und Rakel 5 ist ein Gegendruckzylinder 7 angeordnet, zwischen welchem das Substrat 6, vorzugsweise durch den Gegendruckzylinder 7 geführt, läuft. Dieser Vorrichtung ist eine Einrichtung 9 zur thermischen Behandlung nachgeordnet. Diese Einrichtung 9 kann eine Heizlampe, wie in der Abbildung gezeigt, sein oder auch durch beheizte Rollen verwirklicht werden. Das Sieb 1 kann nach dem Bedrucken noch zusätzlich durch eine weitere vorgesehene Reinigungseinheit 10 gereinigt werden, um eine Verkrustung des Siebbandes 1 zu verhindern.

Demzufolge wird ein flexibles Sieb, vorzugsweise ein feines Gewebe aus Kunststoff- oder feinen Metallfäden über die Walzen 2 geführt. Aus dem Druckmediumgeber 3, welcher über eine Düse (nicht gezeigt), die über eine Pneumatik, eine Piezo- oder thermische Steuerung geregelt wird, verfügt, wird das zu verarbeitende Druckmedium 4 auf das Sieb 1 aufgebracht. Bei dem Druckmedium 4 kann es sich, wie bereits erwähnt, um eine herkömmliche Siebdruckfarbe, ein leitfähiges Polymer, gelöst in Lösungsmittel, beispielsweise Polyanilin PANI in m-Kresol, ein isolierendes Polymer, gelöst in Lösungsmittel, wie Polyhydroxystyrol PHS oder Cymel gelöst in Dioxan oder Butanol, oder ein halbleitendes Polymer, gelöst in Lösungsmittel, wie Polyhexylthiophen P3HT in Chloroform, oder um ein anderes Medium, dessen Viskosität im Bereich von 1 mPas bis etwa 1000 mPas liegt, handeln. Bei schnell verdampfenden Lösungsmitteln, das heißt Siedepunkten unter 80°C, muss das Verfahren unter einer Atmosphäre des entsprechenden Lösungsmittels durchgeführt werden, da ansonsten das Druckmedium 4 in dem Sieb 1 haften bleibt. Das Druckmedium 4 wird je nach Viskosität auf dem Gewebe 1 liegen bleiben oder auch schon beginnen hindurchzusickern. An der sofort darauf folgenden Rakel 5, welche, um das feine Siebgewebe 1 nicht zu beschädigen, aus einem Hartgummi bestehen sollte, wird das Druckmedium 4 durch das Sieb 1 auf das zu bedruckende Substrat 6 übertragen. Bei dem Substrat 6 kann es sich um flexibles Polyethylenterephthalat (PET), Polyethylen (PE) oder Polyimid (PI) handeln. Dabei wird durch die Rakel 5 das noch nicht durch das Sieb 1 gesickerte Druckmedium 4 abgestreift. In Kombination mit dem Druckmediumgeber 3 gewährleistet das einen kontinuierlichen, konstanten Durchsatz von Druckmedium 4 durch das Sieb 1, was wiederum für eine homogene Beschichtung sorgt. Der Druck der Rakel 5 auf das Sieb 1 wird über einen Gegendruckzylinder 7, welcher gleichzeitig auch das Substrat führt, stabilisiert.

Mit dieser Vorrichtung ist es möglich, je nach Vorgabe strukturierte oder unstrukturierte Beschichtungen in homogener Weise und homogener Schichtdicke zu erzeugen.

## Patentansprüche

1. Verfahren zur Erzeugung dünner homogener Schichten mit Hilfe der Siebdrucktechnik, bei dem ein Druckmedium mit einer Viskosität von 1 bis 100 mPas über ein auf wenigstens zwei Walzen geführtes flexibles Siebband kontinuierlich oder diskontinuierlich auf ein zu bedruckendes Substrat übertragen wird.

2. Verfahren nach Anspruch 1, **dadurch gekennzeichnet, dass** man das Druckmedium aus Siebdruckfarbe, Fotolack und/oder organischer Verbindung, gelöst in zur Einstellung der Viskosität geeignetem Lösungsmittel, auswählt.

3. Verfahren nach Anspruch 2, **dadurch gekennzeichnet, dass** die Lösungsmittel aus aliphatischen oder aromatischen Kohlenwasserstoffen mit einem Siedepunkt von ≥ 80°C ausgewählt werden.

4. Verfahren nach Anspruch 2, **dadurch gekennzeichnet, dass** Lösungsmittel mit einem Siedepunkt von ≤ 80°C eingesetzt werden, wobei der Übertrag des Druckmediums unter einer Atmosphäre des entsprechenden Lösungsmittels durchgeführt wird.

5. Verfahren nach einem der Ansprüche 2 bis 4, **dadurch gekennzeichnet, dass** das Druckmedium auf das zu bedruckende Substrat strukturiert übertragen wird oder die Strukturierung in einem nachfolgenden Arbeitsschritt vorgenommen wird.

6. Verfahren nach Anspruch 2, **dadurch gekennzeichnet, dass** die organischen Polymerverbindungen aus isolierenden, halbleitenden und/oder leitenden Polymeren ausgewählt werden.

7. Verfahren nach Anspruch 6, **dadurch gekennzeichnet, dass** die Polymerverbindung Polyanilin (PANI) oder dotiertes Polyethylen (PEDOT) ist.

8. Verfahren nach Anspruch 6, **dadurch gekennzeichnet, dass** die Polymerverbindungen konjugierte Polymere, vorzugsweise Polythiophene, Polythienylvinylene oder Perfluorderivate sind.

9. Verfahren nach Anspruch 6, **dadurch gekennzeichnet, dass** die Polymerverbindung ein Polyhydroxystyrol oder ein Hydroxylgruppen enthaltendes Melamin-Formaldehyd-Harz ist.

10. Verfahren nach einem der Ansprüche 1 bis 9, **dadurch gekennzeichnet, dass** Auftragsmenge und Auftragsdauer des Druckmediums in Abhängigkeit von der gewünschten zu erzeugenden Schichtdicke regelbar ist.

11. Verfahren nach einem der Ansprüche 1 bis 10 zur Erzeugung bzw. zum Aufbau von Polymerelektronik.

12. Verfahren nach einem der Ansprüche 1 bis 11 zur Erzeugung von aktiven Bauteilen einer organischen elektronischen Schaltung.

13. Verfahren nach einem der Ansprüche 1 bis 12 zur Erzeugung von passiven Bauteilen einer organischen elektronischen Schaltung.

## Claims

1. Method for producing thin homogenous layers with the aid of screen printing technology, in which a printing medium with a viscosity of 1 to 100 mPas is transferred, by means of a flexible screen belt led on at least two rollers, continuously or discontinuously onto a substrate to be printed.

2. Method according to Claim 1, **characterized in that** the printing medium is selected from screen printing ink, photoresist and/or organic compound, dissolved in a solvent suitable for setting the viscosity.

3. Method according to Claim 2, **characterized in that** the solvents are selected from aliphatic or aromatic hydrocarbons having a boiling point of ≥ 80°C.

4. Method according to Claim 2, **characterized in that** solvents having a boiling point of ≤ 80°C are used, wherein the transfer of the printing medium is carried out under an atmosphere of the corresponding solvent.

5. Method according to any of Claims 2 to 4, **characterized in that** the printing medium is transferred in patterned fashion onto the substrate to be printed or the patterning is performed in a subsequent workstep.

6. Method according to Claim 2, **characterized in that** the organic polymer compounds are selected from insulating, semiconducting and/or conducting polymers.

7. Method according to Claim 6, **characterized in that** the polymer compound is polyaniline (PANI) or doped polyethylene (PEDOT).

8. Method according to Claim 6, **characterized in that** the polymer compounds are conjugated polymers, preferably polythiophenes, polythienylvinylenes or perfluoro derivatives.

9. Method according to Claim 6, **characterized in that** the polymer compound is a polyhydroxystyrene or a melamine formaldehyde resin containing hydroxyl groups.

10. Method according to any of Claims 1 to 9, **characterized in that** the application quantity and application duration of the printing medium can be controlled depending on the desired layer thickness to be produced.

11. Method according to any of Claims 1 to 10, for the production or for the construction of polymer electronics.

12. Method according to any of Claims 1 to 11 for the production of active components of an organic electronic circuit.

13. Method according to any of Claims 1 to 12 for the production of passive components of an organic electronic circuit.

## Revendications

1. Procédé de production de couches minces homogènes par sérigraphie, dans lequel un fluide d'impression présentant une viscosité de 1 à 100 mPas est transféré de manière continue ou discontinue sur un substrat à imprimer au moyen d'une bande de sérigraphie flexible guidée sur au moins deux rouleaux.

2. Procédé selon la revendication 1, **caractérisé en ce que** l'on sélectionne le fluide d'impression parmi une encre de sérigraphie, une photolaque et/ou un composé organique, dissous dans un solvant approprié pour le réglage de la viscosité.

3. Procédé selon la revendication 2, **caractérisé en ce que** les solvants sont sélectionnés parmi des hydrocarbures aliphatiques ou aromatiques ayant un point d'ébullition ≥ 80°C.

4. Procédé selon la revendication 2, **caractérisé en ce que** l'on utilise des solvants ayant un point d'ébullition ≤ 80°C, dans lequel on effectue le transfert du fluide d'impression dans une atmosphère du solvant correspondant.

5. Procédé selon l'une quelconque des revendications 2 à 4, **caractérisé en ce que** l'on transfère le fluide d'impression de manière structurée sur le substrat à imprimer ou on réalise la structuration dans une étape ultérieure.

6. Procédé selon la revendication 2, **caractérisé en ce que** l'on sélectionne les composés polymères organiques parmi des polymères isolants, semiconducteurs ou conducteurs.

7. Procédé selon la revendication 6, **caractérisé en ce que** le composé polymère est la polyaniline (PANI) ou le polyéthylène dopé (PEDOT).

8. Procédé selon la revendication 6, **caractérisé en ce que** les composés polymères sont des polymères conjugués, de préférence le polythiophène, le polythiénylvinylène ou des dérivés perfluorés.

9. Procédé selon la revendication 6, **caractérisé en ce que** le composé polymère est un polyhydroxystyrène ou une résine mélamine-formaldéhyde contenant des groupes hydroxyle.

10. Procédé selon l'une quelconque des revendications 1 à 9, **caractérisé en ce que** la quantité déposée et la durée de dépôt du fluide d'impression sont réglables en fonction de l'épaisseur de couche désirée à produire.

11. Procédé selon l'une quelconque des revendications 1 à 10 pour produire ou pour construire une électronique polymère.

12. Procédé selon l'une quelconque des revendications 1 à 11 pour produire des composants actifs d'un circuit électronique organique.

13. Procédé selon l'une quelconque des revendications 1 à 12 pour produire des composants passifs d'un circuit électronique organique.
